# FASCICULE DE BREVET EUROPEEN

(11) **EP 3 152 786 B1**
(45) Date de publication et mention de la délivrance du brevet: **04.05.2022**
(21) Numéro de dépôt: 15732422.9
(22) Date de dépôt: 02.06.2015
(51) Int. Cl.: H01L 31/0236, H01L 33/22

(54) **PROCEDE DE TEXTURATION ALEATOIRE D'UN SUBSTRAT SEMI-CONDUCTEUR**
VERFAHREN ZUR WILLKÜRLICHEN TEXTURIERUNG EINES HALBLEITERSUBSTRATS
METHOD FOR THE RANDOM TEXTURING OF A SEMICONDUCTOR SUBSTRATE

(30) Priorité: 04.06.2014 FR 1455068
(43) Date de publication de la demande: 12.04.2017
(73) Titulaire: Université d'Aix Marseille, 13284 Marseille Cedex 07 (FR); Centre National de la Recherche Scientifique (C.N.R.S.), 75016 Paris (FR); THALES, 92200 Neuilly sur Seine (FR)
(72) Inventeur: ESCOUBAS, Ludovic, F-13013 Marseille (FR); BERGINC, Gerard, Jean Louis, F-94320 Thiais (FR); SIMON, Jean-Jacques, F-13124 Peypin (FR); BRISSONNEAU, Vincent, F-83470 St Maximin la Sainte Baume (FR)
(74) Mandataire: Marchand, André
(86) Numéro de dépôt international: PCT/IB2015/054176
(87) Numéro de publication internationale: WO 2015/186064

(56) Documents cités:
- EP-A1- 1 345 275
- WO-A1-2015/043606
- WO-A2-2012/061436
- FR-A1- 2 981 196

## Description

La présente invention concerne un procédé de texturation aléatoire d'un substrat semi-conducteur.

Il est connu que la texturation d'un substrat semi-conducteur, c'est-à-dire le fait de conférer au substrat une rugosité contrôlée, permet d'accroître son absorption optique dans le visible ou l'infrarouge. Les techniques de texturation trouvent ainsi diverses applications dans le domaine de la fabrication des composants optoélectroniques photorécepteurs ou photoémetteurs, notamment les imageurs et les cellules photovoltaïques, pour réaliser des surfaces photofonctionnelles (surfaces réceptrices ou émettrices) anti-réfléchissantes qui améliorent les performances de ces composants.

La présente invention concerne plus particulièrement la texturation d'un substrat semi-conducteur par gravure ionique réactive, cette technique combinant gravure chimique et gravure physique à partir d'une même composition gazeuse ionisée.

L'article "Silicon surface texturing by reactive ion etching" de H.F.W. Dekkers, F. Duerinckx, J. Szlufcik et J. NilS, OPTO-ELECTRONICS REVIEW 8(4), 311-3 16 (2000), décrit un procédé de texturation d'un substrat de silicium de type [111] consistant à soumettre le substrat au processus de gravure ionique réactive. Un tel procédé, souvent utilisé pour le traitement des cellules solaires, ne permet d'obtenir que des rugosités de faible amplitude, inférieure au micromètre, et une faible réduction de la réflectivité du matériau dans des longueurs d'ondes de l'ordre de 400-750 nm, soit dans le visible. De plus, le processus de gravure s'arrête spontanément lorsque la structure cristalline [111] s'est réorganisée à la surface du substrat.

La présente invention vise l'obtention d'une plus forte rugosité, et plus particulièrement la réalisation de motifs rugueux d'une profondeur de l'ordre du micromètre à quelques micromètres, permettant d'améliorer l'absorption dans le proche infrarouge, et plus particulièrement dans le domaine des longueurs d'onde de 1000 à 1200 nm où se situe la majorité des applications d'imagerie nocturne, telles que la vidéo-surveillance infrarouge ou la vision de nuit.

Il peut être démontré que le taux d'absorption offert par une surface rugueuse ordonnée et homogène, par exemple un réseau régulier de cavités sensiblement identiques, dépend de la profondeur des cavités qui le constituent et de leur période, et que la longueur d'onde à laquelle le réseau présente une absorption maximale dépend de la période de ces cavités. Par exemple, l'absorption d'un réseau de cavités identiques d'une période de l'ordre du micromètre et d'une profondeur également de l'ordre du micromètre est maximale au voisinage de la longueur d'onde 1000 nm.

Pour obtenir une rugosité plus élevée que celle que permet la gravure directe d'un substrat, il est connu de faire appel à un masque de gravure.

Par exemple, la demande WO 2010/109692 décrit un procédé pour rendre un substrat rugueux comprenant des étapes de dépôt d'un masque dur sur le substrat, de réalisation d'ouvertures dans le masque au moyen d'un laser, de gravure humide isotrope du substrat au moyen d'une solution acide, à travers les ouvertures, pour former des cuvettes dans le substrat, puis de gravure humide anisotrope des cuvettes au moyen d'une solution alcaline, toujours à travers les ouvertures, pour l'obtention de cavités de forme pyramidale inversée.

Dans un même ordre d'idée, la demande de brevet FR 2 981 196 décrit un procédé de structuration d'un substrat semi-conducteur par gravure de celui-ci à travers une couche sacrificielle ayant été préalablement gravée par photolithographie de manière à former des îlots. Ce procédé permet d'obtenir des cavités de forme sensiblement homogène, ayant des dimensions et des formes sensiblement identiques, en particulier en forme de "V" ou de "U", d'une profondeur de l'ordre de la dizaine de micromètres et jusqu'à quelques dizaines de micromètres.

Ces divers procédés permettent certes de réaliser des cavités très profondes, mais présentent également l'inconvénient de ne permettre de réaliser que des structures régulières, ordonnées et homogènes.

Or, il peut également être démontré qu'une surface de rugosité aléatoire présente, par rapport à une surface constituée de structures homogènes, l'avantage d'offrir une faible réflectivité sur une large gamme de longueurs d'ondes. Schématiquement, on peut en effet considérer qu'un motif de rugosité aléatoire est équivalent à la somme d'un ensemble de réseaux périodiques composés chacun de cavités présentant des profondeurs identiques, mais présentant entre eux des variations de profondeurs et de période spatiale obéissant à une loi de probabilité, par exemple une loi gaussienne. Un tel motif de rugosité aléatoire présente un large spectre d'absorption par combinaison des absorptions de chacun des réseaux qui le constituent virtuellement, chaque réseau présentant une absorption maximale à une longueur d'onde différente de celle des autres.

Il pourrait ainsi être souhaité de prévoir un procédé permettant de fabriquer une surface rugueuse qui n'est pas "déterministe" (c'est-à-dire présentant un motif rugueux généré numériquement) et qui présente un motif rugueux aléatoire défini par une loi de probabilité.

L'article "Statistically modified surfaces: experimental solutions for controlled scattered light" de V. Brissonneau, F. Flory, L. Escoubas, G. Berginc, J. Appl. Phys. 112, 114325 (2012), décrit un procédé permettant d'atteindre un tel objectif. Le procédé comprend une étape de formation, sur le substrat à texturer, d'une couche de résine photosensible comprenant un premier motif rugueux composé de cavités de formes, de profondeurs et de distributions aléatoires. Ce motif est obtenu par une étape de pré-insolation de la couche de résine, suivie d'une étape d'insolation aléatoire de celle-ci au moyen d'un faisceau de lumière laser, puis d'une étape de développement de la résine insolée. L'insolation aléatoire est mise en œuvre au moyen d'un modulateur spatial de lumière utilisant une matrice de micro-miroirs, associé à un élément de diffusion du faisceau laser. La distribution des profondeurs des cavités réalisées dans la résine, ou "hauteurs pics-vallées" ("peak-valley heights"), obéit à une loi de probabilité exponentielle et est comprise entre 0,4 et 1,6 micromètres.

Le procédé comprend ensuite une étape de transfert du motif rugueux aléatoire sur le substrat, par gravure ionique réactive du substrat à travers la couche de résine. Le substrat étant plus rapidement gravé que la résine en raison de sa forte réactivité aux agents chimiques du gaz réactif, il se produit un phénomène "d'amplification" du relief du motif rugueux initial lors de son transfert, les profondeurs des cavités obtenues étant augmentées par un facteur de l'ordre de 2,5 dans les conditions expérimentales décrites par l'article. Par contre, cet accroissement du relief n'affecte pas la loi de distribution des profondeurs de cavités, qui reste inchangée, de sorte que la rugosité obtenue sur le semi-conducteur est elle-même aléatoire.

Ce procédé présente toutefois l'inconvénient d'être complexe à mettre en œuvre, l'insolation d'une résine au moyen d'un modulateur spatial de lumière étant peu adaptée à une fabrication industrielle de composants dans l'industrie de la microélectronique.

Ainsi, il pourrait être souhaité de prévoir un procédé de texturation aléatoire d'un substrat semi-conducteur ne nécessitant pas un modulateur spatial de lumière.

A cet effet, la présente invention se fonde sur l'observation selon laquelle le processus de gravure ionique réactive est, par nature, un processus inhomogène à l'échelle microscopique. Un tel processus, s'il est contrôlé d'une manière appropriée telle que décrite plus loin, fait apparaître à la surface du matériau gravé des cavités microscopiques de profondeurs et de période aléatoires, équivalentes à la somme d'un ensemble de réseaux périodiques composés chacun de cavités présentant des profondeurs identiques et une période constante. La présente invention se fonde également sur l'observation, mise en évidence par le document précité, que le transfert sur un substrat d'un motif rugueux aléatoire réalisé sur une résine a pour effet d'accroître la profondeur du motif, sans altérer son caractère aléatoire. La présente invention se fonde ainsi sur l'idée "d'amplifier", par cette technique de transfert, un motif rugueux aléatoire obtenu en exploitant la propriété d'inhomogénéité de la gravure ionique réactive.

Plus particulièrement, l'invention concerne un procédé de texturation aléatoire d'une surface photofonctionnelle d'un substrat semi-conducteur d'un composant photoémetteur ou photorécepteur, tel qu'exposé dans la revendication 1.

Selon un mode de réalisation, le matériau du masque de gravure est choisi de manière à présenter une vitesse de gravure inférieure à la vitesse de gravure du substrat, avec des paramètres de gravure identiques, de manière que la profondeur aléatoire des cavités du second motif rugueux aléatoire soit statistiquement supérieure à la profondeur aléatoire des cavités du premier motif rugueux aléatoire.

Selon un mode de réalisation, la vitesse de gravure du substrat est au moins 10 fois supérieure à la vitesse de gravure du masque.

Selon un mode de réalisation, le masque de gravure comprend un matériau compris dans le groupe comprenant : les résines photosensibles, les métaux, un oxyde ou un nitrure de silicium.

Selon un mode de réalisation, l'étape de transfert du premier motif rugueux aléatoire est poursuivie jusqu'à disparition du masque de gravure.

Selon un mode de réalisation, l'étape de transfert du premier motif rugueux aléatoire est suivie d'une étape de retrait de résidus du masque de gravure.

Selon un mode de réalisation, l'étape de formation de cavités dans le masque de gravure est réalisée avec des premiers paramètres de gravure ionique réactive, jusqu'à l'apparition d'orifices atteignant le substrat, et l'étape de transfert du premier motif rugueux aléatoire est essentiellement réalisée avec des seconds paramètres de gravure ionique réactive, choisis de manière à ralentir la vitesse de gravure du masque relativement à la vitesse avec laquelle le masque serait gravé si les premiers paramètres de gravure ionique réactive étaient maintenus.

Selon un mode de réalisation, le commencement de l'étape de transfert du premier motif rugueux aléatoire dans le substrat est détecté par détection de la présence d'atomes du matériau du substrat dans un réacteur de gravure ionique réactive.

Selon un mode de réalisation, les paramètres de gravure incluent au moins l'un des paramètres suivants : la pression d'un gaz réactif dans un réacteur de gravure, la tension appliquée à des électrodes d'ionisation du gaz réactif, et la composition du gaz réactif.

Selon un mode de réalisation, le substrat est monocristallin.

Des modes de réalisation de l'invention concernent également un procédé de fabrication d'un composant semi-conducteur photoémetteur ou photorécepteur, comprenant une étape de texturation aléatoire de la surface du substrat du composant selon le procédé de l'invention.

Des modes de réalisation du procédé de l'invention seront décrits dans ce qui suit à titre non limitatif en se référant aux dessins annexés, parmi lesquels :
- la figure 1 représente une étape préparatoire de dépôt d'un masque de gravure sur un substrat dont la surface doit être texturée aléatoirement,
- la figure 2 représente schématiquement un exemple de mise en œuvre, dans un réacteur de gravure ionique réactive, du procédé de texturation aléatoire selon l'invention,
- les figures 3A et 3B sont respectivement des vues en coupe et de dessus du substrat et du masque de gravure à un premier instant d'une première phase du procédé de texturation,
- les figures 4A et 4B sont respectivement des vues en coupe et de dessus du substrat et du masque de gravure à un second instant d'une première phase du procédé de texturation,
- la figure 5 est une vue en coupe du substrat et du masque de gravure à un premier instant d'une seconde phase du procédé de texturation,
- la figure 6 est une vue de dessus du substrat et du masque de gravure à un second instant de la seconde phase,
- la figure 7 est une vue en coupe du substrat et du masque de gravure à un troisième instant de la seconde phase,
- la figure 8 est une vue en perspective du masque de gravure au second instant de la première phase,
- la figure 9 montre un exemple de courbe de distribution des hauteurs pics-vallées d'un motif rugueux aléatoire présent sur le masque au second instant de la première phase,
- la figure 10 est une vue de dessus d'un exemple de substrat texturé aléatoirement selon le procédé de l'invention,
- la figure 11 montre une courbe de distribution des hauteurs pics-vallées d'un motif rugueux aléatoire présent à la surface du substrat de la figure 10,
- la figure 12 montre une courbe de distribution de la période spatiale aléatoire du motif rugueux aléatoire présent à la surface du substrat de la figure 10, et
- la figure 13 est une vue en coupe d'un composant optoélectronique réalisé selon un procédé de fabrication selon l'invention.

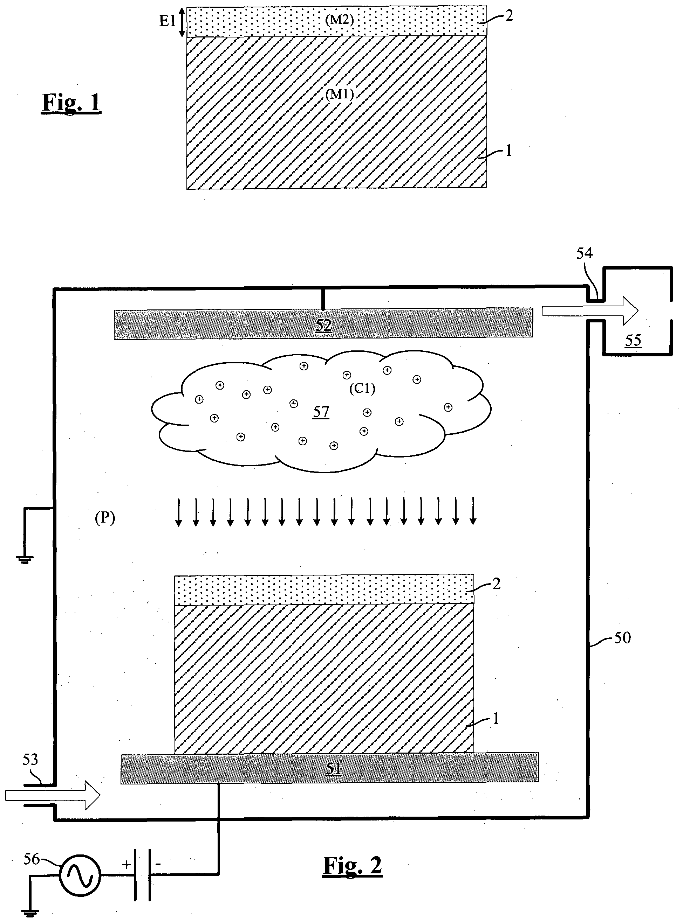

La figure 1 représente schématiquement une étape préliminaire de dépôt d'un masque de gravure 2 sur un substrat 1 dont la surface doit être texturée aléatoirement au moyen du procédé selon l'invention. Le substrat 1 est en un matériau semi-conducteur M1 et le masque de gravure en un matériau M2. Le matériau M2 est de préférence choisi de manière à présenter une vitesse de gravure ionique réactive inférieure à la vitesse de gravure du matériau M1, avec des paramètres de gravure identiques. Dans un mode de réalisation du procédé, la vitesse de gravure du matériau M1 est au moins 10 fois supérieure à celle du matériau M2.

Le matériau M1 est par exemple du silicium monocristallin, et le matériau M2 est par exemple une résine photosensible positive déposée par centrifugation. Le masque de gravure 2 présente une épaisseur E1, par exemple 1 micromètre. Cette épaisseur, est, de préférence, la plus constante possible à l'échelle atomique, afin que des variations de cette épaisseur d'interfèrent pas avec le processus de gravure inhomogène du masque décrit plus loin.

Le procédé de texturation aléatoire selon l'invention est mis en œuvre ici au moyen d'un réacteur 50 de gravure ionique réactive à électrodes parallèles, montré schématiquement sur la figure 2. Le réacteur 50 comporte une électrode inférieure 51 servant de support au substrat 1, une électrode supérieure 52, une entrée de gaz 53 ("inlet"), et une sortie de gaz 54 ("exhaust") reliée à une pompe à vide (non représentée) permettant de maintenir une très basse pression P dans le réacteur. Un analyseur de gaz 55, par exemple un spectromètre de masse, associé à un débitmètre, peut être prévu à la sortie du réacteur. L'électrode inférieure 51 est couplée capacitivement à un générateur 56 de tension alternative. Les parois du réacteur 50 et l'électrode supérieure 52 sont reliées à la masse du générateur 56. Le générateur 56 applique un champ électrique alternatif à l'électrode inférieure, oscillant par exemple à 13,56 Mhz, et fournit une puissance électrique ajustable, par exemple de l'ordre de la centaine de watts.

Le procédé de texturation aléatoire comprend deux phases:
- une phase P1 de gravure du masque de gravure 2 par gravure ionique réactive,
- une phase P2 de gravure du substrat 1 par l'intermédiaire du masque de gravure 2, également par gravure ionique réactive.

### Phase P1

Pour initier la phase P1, un gaz réactif 57 de composition C1, par exemple un gaz fluoré comme du tétrafluorure de carbone CF4, est injecté dans le réacteur 50. Un champ électrique oscillant, présent entre les électrodes 51, 52, ionise les molécules du gaz en leur arrachant des électrons, faisant apparaître un gaz ionisé (plasma) contenant des ions positifs (cations) et des électrons libres. Les électrons libres sont éjectés de la masse gazeuse tandis que les cations, plus lourds et moins réactifs aux variations du champ électrique, restent initialement en suspension entre les électrodes. Les électrons qui atteignent les parois du réacteur 50 ou l'électrode supérieure 52 sont évacués par la masse du générateur 56, tandis que ceux qui atteignent l'électrode inférieure 51 chargent celle-ci à un potentiel statique négatif. Lorsque la différence de potentiel statique entre les électrodes 51, 52 atteint un certain seuil, les ions attirés par l'électrode négative 51 sont fortement accélérés par le champ électrique et sont projetés à la surface du substrat 1, ici sur le masque 2.

Ce processus de gravure est anisotrope et comporte deux composantes de processus qui agissent conjointement sur la surface bombardée par les ions :
- un processus de gravure chimique : les ions réagissent chimiquement avec la surface bombardée, généralement après avoir capturé des électrons libres au voisinage de la surface et avoir formé des radicaux,
- un processus de gravure physique (gravure plasma) lié à l'énergie cinétique des cations, qui arrachent des atomes de la surface bombardée par transfert d'énergie cinétique.

Le processus de gravure chimique est généralement peu actif sur le masque, dont la gravure est essentiellement assurée par gravure physique. L'opérateur peut toutefois contrôler à tout moment la vitesse de gravure physique et la vitesse de gravure réactive en agissant sur des paramètres de gravure tels que la concentration du gaz, la tension inter-électrodes, ou la composition du gaz.

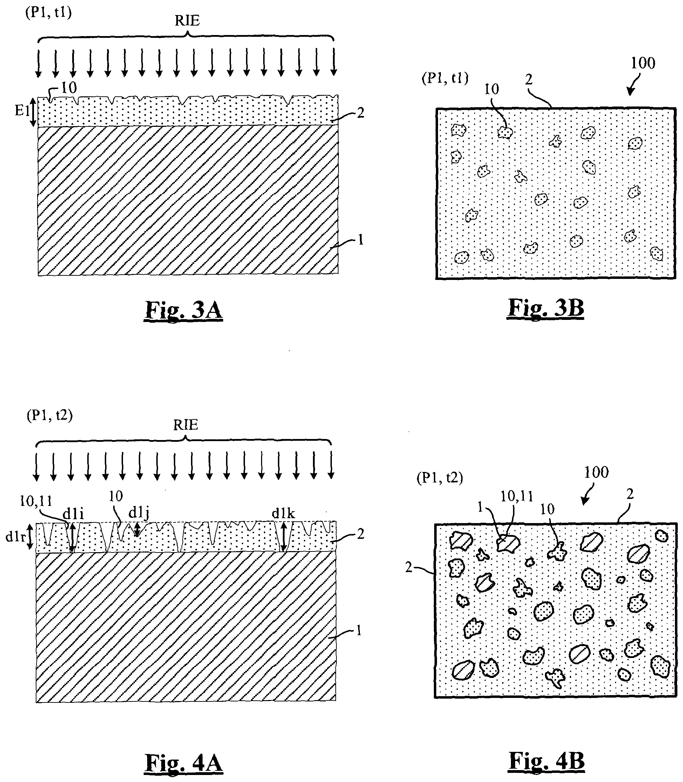

Les figures 3A et 3B sont des vues en coupe et de dessus avec un fort grossissement d'une partie du substrat 1 et du masque de gravure 2 à un instant initial t1 de la phase P1. Le processus de gravure ionique réactive étant configuré selon le procédé de l'invention pour être inhomogène et aléatoire, on voit apparaître à la surface du masque 2 des cavités microscopiques 10 de formes, profondeurs et distribution aléatoires.

Les figures 4A et 4B sont des vues en coupe et de dessus de la même partie du substrat et du masque, à un instant final t2 de la phase P1. Certaines cavités 10 sont devenues des orifices 11 traversant le masque 2 tandis que de nouvelles cavités 10 sont apparues. L'ensemble forme un motif rugueux aléatoire 100 formé de cavités de formes, profondeurs d1i, d1j, d1k et distribution aléatoires.

Selon le procédé de l'invention, l'obtention de ce motif rugueux aléatoire formé de cavités de formes, profondeurs et distribution aléatoires, implique un contrôle du processus de gravure de manière qu'il soit parfaitement inhomogène. Cette inhomogénéité est notamment contrôlée par un ajustement des paramètres suivants :
- la température du substrat,
- le débit des gaz injectés,
- la pression dans l'enceinte du réacteur,
- le flux d'ions bombardant la surface à graver, également appelé densité d'ions, ou encore "puissance RF de la source",
- l'énergie de ces ions, ou "puissance de polarisation appliquée au substrat".

De façon générale, la nature et le débit des gaz injectés, la pression dans l'enceinte, la puissance RF de la source et la puissance de polarisation sont des paramètres intimement liés dont les valeurs respectives provoquent l'inhomogénéité du plasma et de la gravure obtenue.

Un paramètre clé du procédé est la puissance de polarisation appliquée au substrat, soit l'énergie des ions. L'obtention d'une rugosité telle que montrée sur les figures 4A, 4B nécessite que l'on agisse sur la puissance de polarisation, en augmentant cette puissance jusqu'à obtention du résultat souhaité. Il faut donc pouvoir contrôler ce paramètre indépendamment des autres, par le choix d'un réacteur approprié. Une fourchette de valeurs typiques de puissances de polarisation est 10W-100W.

Le réacteur de gravure utilisé doit donc permettre de contrôler de façon indépendante l'énergie des ions (puissance de polarisation) et le flux d'ions (puissance RF de la source). Il doit permettre également de réguler la température du substrat, par exemple autour de 50°C (ceci étant généralement obtenu par écoulement d'un liquide entre le substrat et le porte-substrat), d'opérer à faible pression, par exemple une pression inférieure à 6.6661 Pa (50 mTorr), et d'opérer à des hautes densités d'ions, par exemple supérieures à 10¹⁰ cm⁻³.

Il existe à cet effet deux catégories principales de réacteurs plasma dits "haute densité" pouvant être utilisés, qui diffèrent par la façon dont la puissance électrique est couplée au plasma : les réacteurs utilisant un couplage excitant des ondes progressives dit "ECR" ("Résonance Cyclotronique Electronique"), et les réacteurs à couplage inductif dits "ICP" ("Inductive Coupled Plasma"). Les réacteurs haute densité présentent l'intérêt, outre le fait d'opérer à basse pression (quelques dixièmes de Pa soit quelques mTorr), de contrôler indépendamment le flux et l'énergie des ions qui bombardent la région à graver. A cet effet, ces deux types de réacteurs utilisent deux générateurs RF:
- le premier permet la création du plasma via un couplage inductif (le plus souvent de type ICP) et donc le contrôle du flux ionique bombardant le substrat (puissance RF de la source),
- le second est couplé de manière capacitive au substrat et permet de contrôler l'énergie des ions bombardant ce dernier (puissance de polarisation). Ces deux types de générateurs RF utilisent des fréquences différentes, typiquement 12,56MHz pour le premier et 13,56MHz pour le second.

### Phase P2

La phase P2 de gravure du substrat est initiée lorsque les premiers orifices 11 apparaissent dans le masque de gravure 2. La phase P2 est de préférence mise en œuvre avec des paramètres de gravure ionique réactive différents de ceux de la phase P1, choisis de manière à ralentir la vitesse de gravure du masque relativement à la vitesse avec laquelle il serait gravé si les paramètres de gravure de la phase P1 étaient maintenus, tout en maintenant l'inhomogénéité du processus de gravure.

L'instant où la phase 2 est engagée peut être détecté au moyen de l'analyseur de gaz 55 et du débitmètre, par détection d'atomes du matériau M1 du substrat dans le gaz extrait du réacteur 50, ici des atomes de silicium ou des composés dérivés, par exemple du dioxyde de silicium si la gravure est faite en présence d'oxygène. Alternativement, la fin de la phase P1 peut être déterminée par chronométrage, après étalonnage du procédé. La phase P1 peut également, dans certains modes de réalisation du procédé de l'invention, chevaucher la phase P2, c'est-à-dire comprendre un commencement de gravure du substrat qui se poursuit au cours de la phase P2 avec des paramètres de gravure différents. Également, dans d'autres modes de réalisation, les phases P1 et P2 peuvent être confondues et conduites sans modification des paramètres de gravure, de sorte qu'il n'est alors pas nécessaire de détecter la fin de la phase P1.

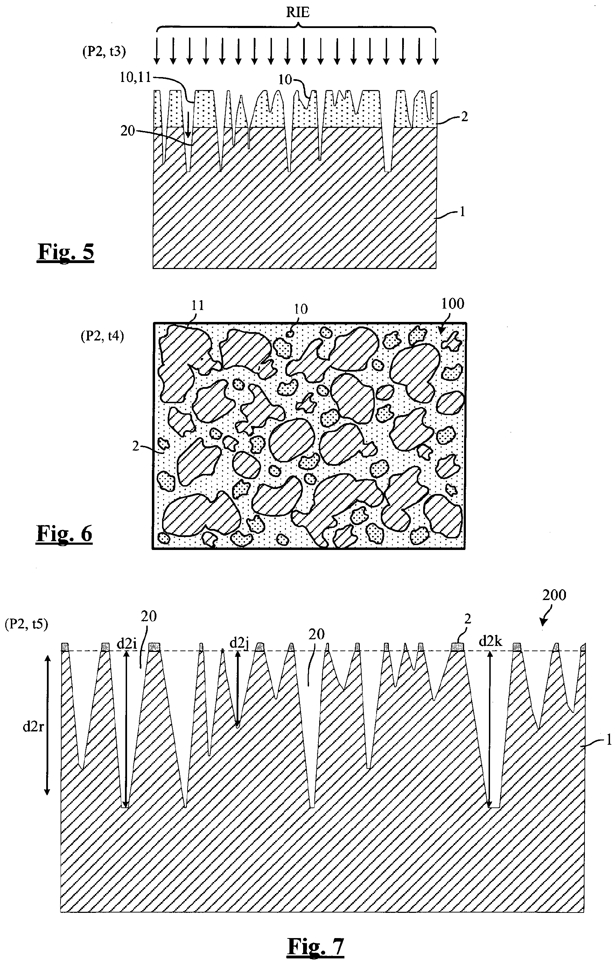

La figure 5 est une vue en coupe de la partie précitée du substrat 1 et du masque 2 à un instant t3 intervenant peu après le commencement de la phase P2. Des cavités 20 apparaissent rapidement dans le substrat 1 par gravure de celui-ci à travers les orifices 11 du masque, tandis que de nouvelles cavités 10 apparaissent dans le masque 2 et que d'autres se transforment en orifices 11, le tout avec une vitesse de gravure inférieure à celle du substrat 1.

La figure 6 est une vue de dessus de la partie précitée du masque 2 à un instant ultérieur t4 de la phase P2. Les cavités 10 créées pendant la phase 1 ont été majoritairement transformées en orifices 11 de plus grande ouverture, dont certains se sont rejoints pour former des orifices d'encore plus grande ouverture, à travers lesquels des cavités 20 ont été gravées dans le substrat, pendant que de nouvelles cavités 10 sont apparues dans le masque et que d'autres se sont transformées en orifices 11.

La figure 7 est une vue en coupe de la partie précitée du substrat 1 et du masque 2 à un instant t5 final ou quasi-final de la phase P2. Le masque 2 ne présente plus qu'une très faible épaisseur, d'une à quelques couches atomiques. Le substrat 1 présente un motif rugueux aléatoire 200 comportant une pluralité de cavités 20 de formes, profondeurs et distribution aléatoires.

La phase P2 peut être poursuivie jusqu'à disparition complète du masque 2. La détection de la disparition du masque peut être faite au moyen de l'analyseur de gaz 55, lorsque des espèces chimiques caractéristiques du matériau M2 ne sont plus détectables. Alternativement, la phase P2 peut être suivie d'une phase P3 de rinçage du substrat visant à retirer les résidus de masque, par exemple un rinçage à l'acétone quand le matériau M2 est une résine.

La phase P2, ou le cas échéant la phase P3, peut être suivie d'une phase P4 d'implantation de dopant à la surface du substrat, en soi classique, permettant d'améliorer l'absorption de la surface rugueuse aléatoire dans un domaine de longueurs d'onde de 1200 nm à 1600 nm. Le dopant peut par exemple être du Soufre, et être implanté par exemple avec des concentrations de l'ordre de 10¹⁴ à 10¹⁶ atomes.cm-2.

Comme cela a été indiqué plus haut, la gravure du substrat à travers le masque de gravure a donc pour effet de transférer sur le substrat le motif rugueux aléatoire 100 du masque, pour obtenir le motif rugueux aléatoire 200. Les profondeurs des cavités 20 (ou hauteurs pics-vallées) formant le motif rugueux 200, notées d2i, d2j, d2k... sur la figure 7, sont fonction des profondeurs initiales des cavités 10 formées dans le masque 2 avant l'engagement de la phase P2, notées d1i, d1j, dlk... sur la figure 4A, avec un facteur d'amplification lié à la différence de vitesse de gravure du substrat relativement à celle du masque.

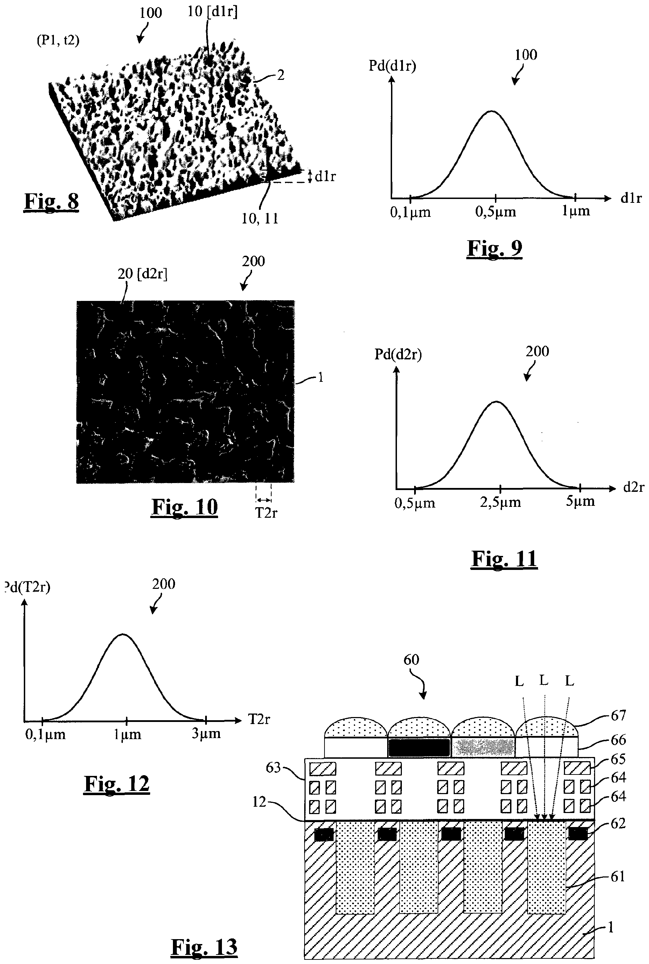

Il peut être démontré que la distribution des profondeurs des cavités 20 du motif 200 obéit à une même loi de probabilité que la distribution des profondeurs des cavités 10 du motif 100. En d'autres termes, le facteur d'amplification des profondeurs des cavités ne modifie pas leur densité de probabilité relative. Pour fixer les idées, la figure 8 montre un exemple de motif rugueux 100 obtenu à l'instant final t2 de la phase P1 (apparition des orifices 11 et commencement de gravure du substrat) et la figure 9 montre la densité de probabilité Pd(d1r) des profondeurs aléatoires d1r des cavités 10 constituant ce motif rugueux. La figure 10 montre un aspect du motif rugueux 200 obtenu au terme de la phase P2, et la figure 11 montre la densité de probabilité Pd(d2r) des profondeurs aléatoires d2r des cavités 20 de ce motif rugueux. Les figures 9 et 11 montrent que les densités de probabilité sont identiques et prennent chacune la forme d'une fonction Gaussienne. Sur la figure 9, les profondeurs d1r des cavités 10 sont comprises entre environ 0,1 micromètre et 1 micromètre. Cette dernière valeur est imposée ici par l'épaisseur E1 du masque 2 et correspond à la profondeur maximale d'une cavité 10 devenue un orifice 11. La courbe Pd(d1r) présente un pic au voisinage de 0,5 micromètre correspondant à la probabilité maximale de profondeur d'une cavité. Sur la figure 11, les profondeurs d2r des cavités 20 sont comprises entre 0,5 micromètre environ et 5 micromètres. La courbe Pd(d2r) présente un pic au voisinage de 2,5 micromètres correspondant à la probabilité maximale de profondeur d'une cavité 20. L'homme de l'art notera que ces valeurs sont exemplatives et peuvent varier dans de larges proportions en fonction des matériaux M1, M2 utilisés et des paramètres de gravure retenus.

La distribution spatiale des cavités obéit elle-même à une loi de probabilité, et la figure 12 montre à titre d'exemple la courbe Pd(T2r) de la densité de probabilité de la période spatiale aléatoire T2r du réseau de cavités 20, considéré ici comme la somme d'un ensemble de réseaux de cavités de période spatiale constante. Dans cet exemple, la période spatiale aléatoire T2r est comprise entre 0,1 micromètre et 3 micromètres et la fonction Pd(T2r) présente un pic au voisinage du micromètre, correspondant à la plus forte probabilité de période spatiale, donc de distance entre deux cavités. L'homme de l'art notera que l'exemple de lois de probabilité représentées sur les figures 9, 11 et 12, ici des Gaussiennes, sont purement exemplatifs et reflètent seulement les expériences conduites. Il n'est donc pas exclu que d'autres lois de probabilité puissent être obtenues avec des variantes du procédé de l'invention.

Comme indiqué plus haut, un tel motif de rugosité aléatoire 200 présente un large spectre d'absorption par combinaison des absorptions de chacun des réseaux qui le constituent virtuellement, chaque réseau présentant une absorption maximale à une longueur d'onde différente de celle des autres. En particulier, un motif rugueux présentant les caractéristiques structurelles susmentionnées (Fig. 9, 11, 12) et réalisé sur un substrat de silicium présente une excellente absorption de l'ordre de 100% entre 800 nm et 1000 nm, de 70 à 80% entre 1000 nm et 1100 nm (vision infrarouge), et de l'ordre de 20% au-delà de 1200 nm et jusqu'à 1600 nm, pouvant être améliorée par la phase de dopage P4.

Le procédé de texturation aléatoire selon la présente invention est susceptible de divers modes de réalisation. Il peut être appliqué à divers types de substrats semiconducteurs, dopés ou non, de préférence monocristallin, en silicium, germanium, sulfure de zinc (ZnS), Séléniure de Zinc (ZnSe), et de façon générale tous les monocristaux. Également, des expérimentations pourraient être conduites sur des substrats multi cristallins, pour déterminer l'applicabilité du procédé à ce type de substrat. Dans certains modes de réalisation, le masque 2 peut être en Chrome ou en Aluminium. Le masque est alors déposé sous vide avec une technologie pour couche mince, et peut être de très faible épaisseur, par exemple 0,1 µm. Divers types de résine photosensibles peuvent aussi être utilisées, négatives ou positives. Un masque en résine positive présente une épaisseur typique de l'ordre de 0,5 micromètre à 2 micromètres tandis qu'un masque en résine négative peut présenter une épaisseur jusqu'à 8 micromètres. Des modes de réalisation du procédé peuvent également utiliser un masque d'oxyde de silicium (SiO2) ou de nitrure de silicium (Si3N4) d'une épaisseur typique de 0,3 micromètre à 2 micromètres, formé par dépôt chimique en phase vapeur. De façon générale, le choix de diverses combinaisons de matériaux M1 et M2 est à la portée de l'homme de l'art, éventuellement après des expérimentations préalables permettant de valider le choix envisagé. Egalement, le processus de gravure ionique réactive peut être mis en œuvre avec divers gaz réactifs, notamment fluorés ou chlorés, comme du tétrafluorure de carbone (CF4) ou de l'hexafluorure de soufre (SF6), avec ou sans oxygène, la présente d'oxygène entraînant la passivation simultanée du substrat si celui-ci est en silicium.

Le procédé de texturation aléatoire selon la présente invention est également susceptible de diverses applications, notamment dans le cadre de la fabrication de composants optoélectroniques photorécepteurs ou photoémetteurs nécessitant une surface photofonctionnelle antireflet pour optimiser la collecte ou l'émission de photons, par exemple les cellules solaires photovoltaïques et les capteurs d'image. A titre d'exemple, la figure 13 représente schématiquement un imageur CMOS 60 réalisé selon un procédé de fabrication selon l'invention incluant une étape de texturation aléatoire de la surface photofonctionnelle de l'imageur. Après implantation de photodiodes 61 et de transistors 62 dans le substrat 1 de l'imageur, ainsi que divers éléments d'interconnexion non représentés dans un souci de simplicité du dessin, la surface 12 du substrat 1 est soumise à un procédé de texturation selon l'invention. Après retrait du masque de gravure aléatoire et dopage éventuel du substrat, ce dernier est recouvert par une couche diélectrique 63 recevant des pistes d'interconnexion 64 en métal et un masque de lumière 65, puis par un filtre de couleur RVB 66 et des microlentilles 67 qui focalisent des rayons lumineux incidents (L) sur les régions de photodiodes 61.

## Revendications

1. Procédé de texturation aléatoire d'une surface photofonctionnelle d'un substrat semi-conducteur (1) d'un composant photoémetteur ou photorécepteur (60), comprenant des étapes consistant à :
- déposer un masque de gravure (2) sur le substrat (1),
- former un premier motif rugueux aléatoire (100) dans le masque de gravure, ledit motif comprenant une pluralité de cavités (10, 11) de formes, profondeurs (dlr) et distribution aléatoires, ledit motif étant formé par gravure ionique réactive, dans un réacteur permettant un contrôle de l'énergie des ions assurant la gravure ionique réactive indépendamment du contrôle de la densité de ces ions,
- transférer dans le substrat (1), par gravure ionique réactive du substrat, le premier motif rugueux aléatoire (100), pour obtenir à la surface du substrat un second motif rugueux aléatoire (200) composé de cavités (20) de formes, profondeurs (d2r) et distribution aléatoires, ce transfert continuant à graver le masque à une vitesse plus faible qu'au cours de la formation du motif rugueux,
procédé comprenant une étape de réglage de l'énergie des ions consistant à augmenter l'énergie des ions jusqu'à l'obtention d'une gravure non homogène du masque de gravure et l'obtention de ladite pluralité de cavités (10, 11) de formes, profondeurs (dlr) et distribution aléatoires.

2. Procédé selon la revendication 1, dans lequel le matériau (M2) du masque de gravure (2) est choisi de manière à présenter une vitesse de gravure inférieure à la vitesse de gravure du substrat, avec des paramètres de gravure identiques, de manière que la profondeur aléatoire (d2r) des cavités du second motif rugueux aléatoire (200) soit statistiquement supérieure à la profondeur aléatoire (d1r) des cavités du premier motif rugueux aléatoire.

3. Procédé selon la revendication 2, dans lequel la vitesse de gravure du substrat (1) est au moins 10 fois supérieure à la vitesse de gravure du masque (2).

4. Procédé selon l'une des revendications 1 à 3, dans lequel le masque de gravure comprend un matériau compris dans le groupe comprenant : les résines photosensibles, les métaux, un oxyde ou un nitrure de silicium.

5. Procédé selon l'une des revendications 1 à 4, dans lequel l'étape de transfert du premier motif rugueux aléatoire est poursuivie jusqu'à disparition du masque de gravure.

6. Procédé selon l'une des revendications 1 à 4, dans lequel l'étape de transfert du premier motif rugueux aléatoire est suivie d'une étape de retrait de résidus du masque de gravure.

7. Procédé selon l'une des revendications 1 à 6, dans lequel
- l'étape de formation de cavités (10, 11) dans le masque de gravure est réalisée avec des premiers paramètres de gravure ionique réactive, jusqu'à l'apparition d'orifices (11) atteignant le substrat, et
- l'étape de transfert du premier motif rugueux aléatoire est essentiellement réalisée avec des seconds paramètres de gravure ionique réactive, choisis de manière à ralentir la vitesse de gravure du masque relativement à la vitesse avec laquelle le masque serait gravé si les premiers paramètres de gravure ionique réactive étaient maintenus.

8. Procédé selon la revendication 7, dans lequel le commencement de l'étape de transfert du premier motif rugueux aléatoire dans le substrat est détecté par détection de la présence d'atomes du matériau (M1) du substrat dans un réacteur de gravure ionique réactive.

9. Procédé selon la revendication 7, dans lequel les paramètres de gravure incluent au moins l'un des paramètres suivants : la pression d'un gaz réactif dans un réacteur de gravure, la tension appliquée à des électrodes d'ionisation du gaz réactif, et la composition du gaz réactif.

10. Procédé selon l'une des revendications 1 à 9, dans lequel le substrat est monocristallin.

11. Procédé de fabrication d'un composant semi-conducteur photoémetteur ou photorécepteur (60), comprenant une étape de texturation aléatoire de la surface du substrat du composant au moyen du procédé selon l'une des revendications 1 à 10.

## Patentansprüche

1. Verfahren zum zufälligen Texturieren einer photofunktionalen Oberfläche eines Halbleitersubstrats (1) eines strahlungsemittierenden oder strahlungsempfangenden Bauelements (60), das die folgenden Schritte umfasst:
- Abscheiden einer Ätzmaske (2) auf dem Substrat (1),
- Ausbilden eines ersten zufälligen rauen Musters (100) in der Ätzmaske, wobei das Muster mehrere Vertiefungen (10, 11) mit zufälliger Form, Tiefe (d1r) und Verteilung umfasst, wobei das Muster durch reaktives lonenätzen in einem Reaktor ausgebildet wird, der eine Steuerung der Energie der Ionen, die das reaktive lonenätzen gewährleisten, unabhängig von der Steuerung der Dichte dieser Ionen, ermöglicht,
- Übertragen, durch reaktives lonenätzen des Substrats, des ersten zufälligen rauen Musters (100) in das Substrat (1) zum Erhalten eines zweiten zufälligen rauen Musters (200) auf der Oberfläche des Substrats, das aus Vertiefungen (20) mit zufälliger Form, Tiefe (d2r) und Verteilung besteht, wobei diese Übertragung die Maske mit einer geringeren Geschwindigkeit als während der Ausbildung des rauen Musters weiter ätzt,
wobei das Verfahren einen Schritt eines Einstellens der Energie der Ionen umfasst, der darin besteht, die Energie der Ionen zu erhöhen, bis eine nicht homogene Ätzung der Ätzmaske erhalten wird und die mehreren Vertiefungen (10, 11) mit zufälliger Form, Tiefe (d1r) und Verteilung erhalten werden.

2. Verfahren nach Anspruch 1, wobei das Material (M2) der Ätzmaske (2) gewählt wird, so dass es bei identischen Ätzparametern eine kleinere Ätzgeschwindigkeit als die Ätzgeschwindigkeit des Substrats aufweist, so dass die zufällige Tiefe (d2r) der Vertiefungen des zweiten zufälligen rauen Musters (200) statistisch größer als die zufällige Tiefe (d1r) der Vertiefungen des ersten zufälligen rauen Musters ist.

3. Verfahren nach Anspruch 2, wobei die Ätzgeschwindigkeit des Substrats (1) wenigstens 10-mal größer als die Ätzgeschwindigkeit der Maske (2) ist.

4. Verfahren nach einem der Ansprüche 1 bis 3, wobei die Ätzmaske ein Material umfasst, das in der Gruppe umfasst ist, die Folgendes umfasst: Fotoresists, Metalle, ein Oxid oder ein Siliziumnitrid.

5. Verfahren nach einem der Ansprüche 1 bis 4, wobei der Schritt des Übertragens des ersten zufälligen rauen Musters fortgesetzt wird, bis die Ätzmaske verschwindet.

6. Verfahren nach einem der Ansprüche 1 bis 4, wobei auf den Schritt des Übertragens des ersten zufälligen rauen Musters ein Schritt eines Entfernens von Rückständen der Ätzmaske folgt.

7. Verfahren nach einem der Ansprüche 1 bis 6, wobei:
- der Schritt des Ausbildens von Vertiefungen (10, 11) in der Ätzmaske mit ersten Parametern des reaktiven Ionenätzens durchgeführt wird, bis Öffnungen (11) auftreten, die das Substrat erreichen, und
- der Schritt des Übertragens des ersten zufälligen rauen Musters im Wesentlichen mit zweiten Parametern des reaktiven Ionenätzens durchgeführt wird, die gewählt sind, so dass sie die Ätzgeschwindigkeit der Maske relativ zu der Geschwindigkeit verlangsamen, mit der die Maske geätzt würde, wenn die ersten Parameter des reaktiven Ionenätzens beibehalten werden.

8. Verfahren nach Anspruch 7, wobei der Beginn des Schritts des Übertragens des ersten zufälligen rauen Musters in das Substrat durch Erfassen des Vorhandenseins von Atomen des Materials (M1) des Substrats in einem Reaktor für reaktives lonenätzen erfasst wird.

9. Verfahren nach Anspruch 7, wobei die Ätzparameter wenigstens einen der folgenden Parameter einschließen: den Druck eines Reaktionsgases in einem Ätzreaktor, die Spannung, die an Ionisationselektroden des Reaktionsgases angelegt wird, und die Zusammensetzung des Reaktionsgases.

10. Verfahren nach einem der Ansprüche 1 bis 9, wobei das Substrat monokristallin ist.

11. Verfahren zum Herstellen eines strahlungsemittierenden oder strahlungsempfangenden Halbleiterbauelements (60), das einen Schritt des zufälligen Texturierens der Oberfläche des Substrats des Bauelements mittels des Verfahrens nach einem der Ansprüche 1 bis 10 umfasst.

## Claims

1. Method for randomly texturing a photofunctional surface of a semiconductor substrate (1) of a light-emitting or light-receiving component (60), comprising the steps of:
- depositing an etch mask (2) on the substrate (1),
- forming a first random rough pattern (100) in the etch mask, said pattern comprising a plurality of cavities (10, 11) of random shapes, depths (d1r) and distribution, said pattern being formed by reactive ion etching, in a reactor which allows control of the energy of the ions providing the reactive ion etching independently of the control of the density of these ions,
- transferring the first random rough pattern (100) into the substrate (1) by reactive ion etching of the substrate in order to obtain, on the surface of the substrate, a second random rough pattern (200) consisting of cavities (20) of random shapes, depths (d2r) and distribution, this transfer continuing to etch the mask at a slower rate than during the formation of the rough pattern,
method comprising a step of adjusting the energy of the ions by increasing the energy of the ions until inhomogeneous etching of the etch mask is obtained and said plurality of cavities (10, 11) of random shapes, depths (d1r) and distribution are obtained.

2. Method according to claim 1, wherein the material (M2) of the etch mask (2) is selected so as to have an etching rate lower than the etching rate of the substrate, with identical etching parameters, such that the random depth (d2r) of the cavities of the second random rough pattern (200) is statistically greater than the random depth (d1r) of the cavities of the first random rough pattern.

3. Method according to claim 2, wherein the etching rate of the substrate (1) is at least 10 times greater than the etching rate of the mask (2).

4. Method according to any of claims 1 to 3, wherein the etch mask comprises a material from the group comprising: photosensitive resins, metals, an oxide or a silicon nitride.

5. Method according to any of claims 1 to 4, wherein the step of transferring the first random rough pattern is continued until the etch mask disappears.

6. Method according to any of claims 1 to 4, wherein the step of transferring the first random rough pattern is followed by a step of removing residues from the etch mask.

7. Method according to any of claims 1 to 6, wherein:
- the step of forming cavities (10, 11) in the etch mask is carried out with first reactive ion etching parameters until the appearance of holes (11) reaching the substrate, and
- the step of transferring the first random rough pattern is essentially performed with second reactive ion etching parameters which are selected to slow the etching rate of the mask relative to the rate at which the mask would be etched if the first reactive ion etching parameters were maintained.

8. Method according to claim 7, wherein the beginning of the step of transferring the first random rough pattern into the substrate is detected by detecting the presence of atoms of the material (M1) of the substrate in a reactive ion etching reactor.

9. Method according to claim 7, wherein the etching parameters include at least one of the following parameters: the pressure of a reactant gas in an etching reactor, the voltage applied to electrodes for ionizing the reactant gas, and the composition of the reactive gas.

10. Method according to any of claims 1 to 9, wherein the substrate is monocrystalline.

11. Method for producing a light-emitting or light-receiving semiconductor component (60), comprising a step of randomly texturing the surface of the substrate of the component by means of the method according to any of claims 1 to 10.
